# EUROPÄISCHE PATENTSCHRIFT

(11) **EP 2 149 037 B1**
(45) Veröffentlichungstag und Bekanntmachung des Hinweises auf die Patenterteilung: **04.09.2019**
(21) Anmeldenummer: 08750089.8
(22) Anmeldetag: 06.05.2008
(51) Int. Cl.: G02B 21/00, H01L 31/107, G01J 1/44, G01J 1/46, G01J 3/28

(54) **VORRICHTUNG ZUR LICHTDETEKTION IN EINEM SCANMIKROSKOP**
APPARATUS FOR THE DETECTION OF LIGHT IN A SCANNING MICROSCOPE
DISPOSITIF DE DÉTECTION DE LUMIÈRE DANS UN MICROSCOPE À BALAYAGE

(30) Priorität: 22.05.2007 DE 102007024074
(43) Veröffentlichungstag der Anmeldung: 03.02.2010
(73) Patentinhaber: Leica Microsystems CMS GmbH, 35578 Wetzlar (DE)
(72) Erfinder: BIRK, Holger, 74909 Meckesheim (DE); SEYFRIED, Volker, 69226 Nussloch (DE)
(74) Vertreter: Schaumburg und Partner Patentanwälte mbB
(86) Internationale Anmeldenummer: PCT/EP2008/055537
(87) Internationale Veröffentlichungsnummer: WO 2008/141919

(56) Entgegenhaltungen:
- EP-A- 1 132 725
- WO-A-03/098200
- WO-A-2005/048319
- WO-A2-2004/099865
- DE-A1-102004 003 993
- ROCHAS A ET AL: "Actively recharged single photon counting avalanche photodiode integrated in an industrial CMOS process" SENSORS AND ACTUATORS A, ELSEVIER SEQUOIA S.A., LAUSANNE, CH, Bd. 110, Nr. 1-3, 1. Februar 2004 (2004-02-01), Seiten 124-129, XP004486557 ISSN: 0924-4247

## Beschreibung

### Gebiet der Erfindung

Die Erfindung betrifft ein Zeilenscanmikroskop mit einem Lichtdetektor.

### Stand der Technik

Scanmikroskope werden in den verschiedensten Bereichen der Technik und Naturwissenschaften eingesetzt. Ein Grundprinzip derartiger Scanmikroskope besteht darin, dass ein oder mehrere Mikroskopstrahlen mittels einer Strahlablenkeinrichtung in einer oder mehreren Dimensionen abgelenkt werden, um so eine Probe abzurastern (Scan).

Scanmikroskope sind in verschiedenen Varianten bekannt, welche sich beispielsweise in der Art und Erzeugung des Mikroskopstrahles unterscheiden. So können beispielsweise elektromagnetische Strahlen im optischen, infraroten oder ultravioletten Bereich des Spektrums eingesetzt werden, oder auch in anderen Bereichen des elektromagnetischen Spektrums, beispielsweise im Röntgenbereich. Auch andere Arten von Strahlen sind möglich, beispielsweise Partikelstrahlen in Form von Elektronenstrahlen oder geladenen oder neutralen Teilchen. Auch die gleichzeitige Verwendung mehrerer Mikroskopstrahlen ist denkbar.

Weitere Unterschiede zwischen den verschiedenen Arten von Scanmikroskopen ergeben sich aus der Wechselwirkung des bzw. der Mikroskopstrahlen mit der zu untersuchenden Probe. Bei der folgenden Beschreibung wird im Wesentlichen auf Fluoreszenzmikroskope Bezug genommen, bei welchen der Mikroskopstrahl eine Probenfluoreszenz anregt, welche erfasst werden kann und zur Bildaufnahme genutzt werden kann. Daneben existieren jedoch zahlreiche weitere Messprinzipien, beispielsweise Messprinzipien, welche auf laserspektroskopischen Verfahren beruhen, Messprinzipien, welche auf einer Teilchenemission beruhen, oder andere Messprinzipien. Die nachfolgende Erfindung ist grundsätzlich auf alle derartigen Verfahren anwendbar.

Eine grundlegende Problematik, welche bei vielen der oben beschriebenen Mikroskope und anderen bildgebenden Verfahren eine wesentliche Rolle spielt, ist das Signal-zu-Rauschverhältnis bzw. die Signalstärke der zu detektierenden Signale. Insbesondere bei der Fluoreszenzmikroskopie macht sich hierbei die Sättigung der eingesetzten Farbstoffe bemerkbar, welche das maximal mögliche Signal pro Pixel begrenzt. Je nach Scangeschwindigkeit und Bildformat stehen häufig zu wenige Fluoreszenz-Photonen zur Verfügung. Typische Zeiten, während derer ein einzelnes Pixel eines Detektors während eines Scanvorgangs beleuchtet wird, betragen wenige Nanosekunden bis wenige 10 Nanosekunden. Beispielsweise stehen bei einer resonant bidirektionalen Scanvorrichtung mit einer Scangeschwindigkeit von 16.000 Zeilen pro Sekunde und 1.024 Punkten pro Zeile in der Bildmitte typischerweise 25 Nanosekunden pro Pixel zur Verfügung. Für ein Signal-zu-Rausch-Verhältnis von 20 wären 400 detektierte Photonen pro Pixel erforderlich (Schrotrauschen). Dies entspricht 1,6 · 10¹⁰ detektierten Photonen pro Sekunde oder, bei einer angenommenen Wellenlänge von 600 nm (3,3 · 10⁻¹⁹ J/Photon), einer Fluoreszenzleistung der tatsächlich detektierten Photonen von 5,3 nW. Unter der Annahme, dass nur ein Viertel der Photonen von der Probe zum Detektor gelangen und dass dieser Detektor nur etwa ein Viertel der ankommenden Photonen detektiert, müssen von der Probe mindestens ca. 84,8 nW an Fluoreszenzleistung ausgehen. Bei einer angenommenen Fluoreszenz-Lebensdauer von 5 · 10⁻⁹ s entspricht dies 1.280 Farbstoffmolekülen, welche permanent (gesättigt) im Fokus emittieren müssen. Dieses Rechenbeispiel zeigt, dass das Signal-zu-Rausch-Verhältnis bei Scanmikroskopen ein grundsätzliches Problem darstellt, da für die Sammlung von Lichtquanten für einzelne Pixel verfahrensbedingt nur eine äußerst beschränkte Zeit zur Verfügung steht. Eine Erhöhung dieser Zeit bedeutet jedoch eine Erhöhung der Zeit für einen Bildaufbau, was mit Unbequemlichkeiten für einen Benutzer verbunden ist und/oder was beispielsweise im Falle von schnell veränderlichen Proben zu Unschärfen im Bild führen kann.

Bei den üblicherweise als Bilddetektoren in Mikroskopen verwendeten CCD-Chips (Charge-coupled Device) tritt zusätzlich die Schwierigkeit eines verstärkten Rauschens hinzu. So ist bei CCDs, zusätzlich zum Schrotrauschen, insbesondere bei kleinen Signalpegeln das Ausleserauschen oft dominierend und nimmt mit zunehmender Geschwindigkeit in der Regel noch zu. Zudem ist die optische Auflösung im Vergleich zum Punktscanner bei einem Linienscanner verringert. Die Geschwindigkeit wird vor allem durch die Framerate der Kamera vorgegeben. Für die besonders empfindlichen EMCCDs liegen die maximalen Pixelraten derzeit bei ca. 35 MHz, was einer Framerate bei 1 k · 1 k von 30 Frames pro Sekunde entspricht.

Anstelle von CCD-Bilddetektoren sind aus dem Stand der Technik auch andere Arten von Bilddetektoren bekannt. Für die für die Scanmikroskopie erforderlichen hohen Geschwindigkeiten eignen sich dabei insbesondere so genannte Avalanche-Halbleiterdioden (Lawinen-Photodioden), welche auf dem Effekt einer internen Ladungsverstärkung beruhen. Avalanche-Halbleiterdioden (im Folgenden auch kurz APDs genannt) sind hochempfindliche, schnelle Photodioden, welche beispielsweise auf Silizium-Basis aufgebaut sein können. Übliche APDs nutzen beispielsweise InGaAs-InP-Mehrschichtaufbauten. APDs können in einem linearen Bereich betrieben werden, in welchem das Stromsignal zumindest näherungsweise linear mit der Zahl der eingestrahlten Photonen verläuft, und, oberhalb einer Durchbruchspannung, in einem nicht-linearen Bereich, in welchem der genannte Lawineneffekt auftritt und welcher auch als Geiger-Bereich bezeichnet wird.

Die Verwendung von APD-Detektoren, auch in Array-Form, ist verschiedentlich auch für den Bereich der Mikroskopie vorgeschlagen worden. So beschreibt beispielsweise DE 10 2005 059 948 A1 einen Detektor, welcher insbesondere zur spektralen Detektion von Licht in einem Mikroskop eingesetzt werden kann. Hierbei wird unter anderem vorgeschlagen, den Detektor mit einem APD-Array auszugestalten.

Auch DE 10 2004 003 993 A1 beschreibt die Verwendung eines APD-Arrays. Dabei wird vorgeschlagen, Licht einer räumlich begrenzten Quelle spektral aufzuspalten und das Spektrum mittels eines APD-Arrays aufzunehmen. Ein weiterer APD-Detektor ist aus WO 03/098200 bekannt.

APD-Arrays sind mittels dem Fachmann bekannter halbleitertechnischer Herstellungsverfahren herstellbar. Ein Beispiel eines derartigen Herstellungsverfahrens ist in US 4,458,260 aufgeführt. Dort wird ein APD-Array beschrieben, welches eine Vielzahl von p-n-Übergängen aufweist. Verschiedene Schichtaufbauten für APDs und APD-Arrays sind aus dem Stand der Technik bekannt. Trotz der in der Vergangenheit mehrfach vorgeschlagenen Verwendung von APD-Arrays im Bereich der Mikroskopie stellt jedoch die Verwendung derartiger Arrays nach wie vor bislang eine technische Herausforderung dar. Eine Schwierigkeit besteht insbesondere darin, die großen Datenmengen geeignet aufzunehmen und mit einer entsprechenden Geschwindigkeit zu verarbeiten. Gleichzeitig stellt in vielen Fällen die Totzeit, welche bei APDs ein bekanntes Phänomen ist, eine Schwierigkeit dar, da diese die Anzahl der innerhalb der für 1 Pixel zur Verfügung stehenden Bildaufnahmezeit zusätzlich reduziert und die Schwankungen der Zählraten erhöht.

Aus der DE 10 2004 003 993 A1 ist eine für die Verwendung in einem Fluoreszenzmikroskop bestimmte Vorrichtung bekannt, bei der das von einem einzigen Objektpunkt ausgehende Licht mittels einer Zylinderlinse oder eines Prismas räumlich auf mehrere Halbleiterdetektoren verteilt wird, um so die Möglichkeit zu haben, unter Berücksichtigung einer vorgegebenen Totzeit der Halbleiterdetektoren die Lichtensität zu erhöhen. Den Halbleiterdetektoren sind Photonenzähler zugeordnet, die ihre Zählergebnisse einem Addierer zuführen, der die Zählergebnisse aufsummiert und die so ermittelte Summen als Ausgangssignal bereitstellt. Eine Auswertung der einzelnen, von den Halbleiterdetektoren gelieferten Signale, die für die Aufnahme mehrerer Bildpunkte einer gesamten Bildzeile erforderlich ist, ermöglicht diese Vorrichtung nicht.

### Aufgabe der Erfindung

Es ist daher eine Aufgabe der vorliegenden Erfindung, ein Zeilenmikroskop mit einem Lichtdetektor bereitzustellen, welcher die oben beschriebenen Probleme bekannter Vorrichtungen vermeidet. Insbesondere soll der Lichtdetektor eine schnelle und zuverlässige Aufnahme von Bilddaten ermöglichen.

### Beschreibung der Erfindung

Diese Aufgabe wird durch ein Zeilenmikroskop gemäß dem Anspruch 1 gelöst. Vorteilhafte Weiterbildungen der Erfindung, welche einzeln oder in Kombination realisiert werden können, sind in den abhängigen Ansprüchen dargestellt.

Es wird ein Zeilenmikroskop mit einem Lichtdetektor vorgeschlagen.Ein derartiges Zeilenscanmikroskop ist ein Scanmikroskop, bei welchem jeweils eine Zeile einer Probe abgetastet wird, wobei Daten von allen Punkten dieser Zeile gleichzeitig aufgenommen werden.

Der Lichtdetektor umfasst ein Zeilenarray von Halbleiterphotodioden, wobei das Zeilenarray eine Vielzahl von Avalanche-Halbleiterdioden umfasst. Insbesondere kann es sich bei diesen Avalanche-Photodioden bzw. dem Zeilenarray um ein nach bekannten Halbleitertechniken aufgebautes Array handeln, beispielsweise ein monolithisches Zeilenarray, beispielsweise ein Zeilenarray, wie es in US 4,458,260 beschrieben ist. Auch andere bekannte Herstellungstechniken für das Zeilenarray und die darin umfassten Avalanche-Halbleiterdetektoren sind möglich, beispielsweise eine nicht-monolithische Aufbauweise. Beispielsweise können wiederum InP-InGaAs-Heterojunction-Photodioden verwendet werden.

Allgemein sind Avalanche-Halbleiterdetektoren ausgestaltet, dass sie eine interne Ladungsträgerverstärkung ausnutzen können, zur Detektion schwacher Lichtsignale, wie sie zum Beispiel bei der Messung von Streulicht auftreten. Typische Detektorflächen einzelner Avalanche-Halbleiterdetektoren des Zeilenarrays liegen in der Größenordnung von ca. 100 µm · 100 µm, wobei Kantenlängen der aktiven Flächen zwischen 20 µm und 50 µm bevorzugt sind. Dabei müssen die Detektorflächen nicht notwendigerweise quadratisch sein, so dass beispielsweise auch rechteckige Flächen möglich sind, z.B. Flächen mit einer Kantenlänge von 10 µm x 100 µm. Der "Pitch", also der Abstand des Mittelpunkts eines Avalanche-Halbleiterdetektors zum Mittelpunkt des benachbarten Avalanche-Halbleiterdetektors, beträgt ebenfalls zwischen einigen 10 bis einigen 100 µm. Bevorzugt ist es, wenn das Zeilenarray einen linearen Füllfaktor (Verhältnis der Breite der aktiven Fläche eines Avalanche-Halbleiterdetektors zum Pitch) mindestens 50 Prozent beträgt, vorzugsweise mindestens 70 Prozent und besonders bevorzugt mindestens 80 Prozent.

Das Zeilenarray soll derart ausgestaltet sein, dass dieses Bildpunkte einer gesamten Bildzeile eines Mikroskopbildes aufnehmen kann. Zu diesem Zweck ist es bevorzugt, wenn das Zeilenarray mindestens 256 Avalanche-Halbleiterdetektoren umfasst, vorzugsweise 512 Avalanche-Halbleiterdetektoren und besonders bevorzugt 1.024 Halbleiterdetektoren. Auch höhere Anzahlen sind jedoch denkbar und mit üblichen Halbleiterstrukturierungstechniken realisierbar.

Weiterhin weist der Lichtdetektor gemäß der vorliegenden Erfindung eine elektronische Ansteuerschaltung auf, welche ausgestaltet ist, um die Avalanche-Halbleiterdetektoren in einem Geiger-Modus mit interner Ladungsverstärkung zu betreiben. Alternativ oder zusätzlich ist jedoch auch ein Betrieb in einem linearen Modus möglich. Insbesondere ist es dabei bevorzugt, wenn die Ansteuerschaltung eingerichtet ist, um die Avalanche-Halbleiterdetektoren in einem Ein-Photonen-Modus (Single Photon Mode) zu betreiben, d. h. dass ein einzelner Lichtpuls oder ein Signal eines Avalanche-Halbleiterdetektors jeweils einem einzelnen Photon entspricht bzw. dass der Avalanche-Halbleiterdetektor ausgestaltet ist, um einzelne Photonen zu detektieren. Derartige Single Photon-APDs sind aus dem Stand der Technik bekannt.

Weiterhin weist die Ansteuerschaltung mindestens einen Parallelzähler auf, welcher eingerichtet ist, um während einer vorgegebenen Zählzeit die von den einzelnen Avalanche-Halbleiterdetektoren detektierten Lichtpulse zu summieren. Wie oben ausgeführt, kann es sich bei diesen "Lichtpulsen" insbesondere um einzelne Signale handeln, insbesondere um einzelne Strom- oder Spannungssignale, welche einzelnen Photonen entsprechen, die von dem Avalanche-Halbleiterdetektor des Zeilenarrays aufgenommen wurden. Die vorgegebene Zählzeit kann dabei beispielsweise durch den Parallelzähler vorgegeben werden, derart, dass lediglich während der vorgegebenen Zählzeit Pulse gezählt werden. Alternativ oder zusätzlich kann auch beispielsweise der Avalanche-Halbleiterdetektor derart ausgestaltet sein, dass dieser lediglich während der Zählzeit überhaupt Lichtpulse detektiert, beispielsweise indem der Avalanche-Halbleiterdetektor lediglich während dieser Zählzeit mit einer entsprechenden Vorspannung beaufschlagt wird. Die Zählzeit kann dabei vorzugsweise der Scangeschwindigkeit des Scanmikroskops entsprechen, beispielsweise den eingangs genannten 25 Nanosekunden pro Pixel. Insbesondere kann sich die Zählzeit aus der für eine einzelne Zeile zur Verfügung stehenden Zeit ergeben, wobei jedoch auch ungenutzte Zeiträume während des Übergangs zwischen benachbarten Zeilen auftreten können.

Für den Einsatz in der Scanmikroskopie bietet das Zeilenarray im Vergleich zum Punktscanner den wesentlichen Vorteil, dass die für die Detektion von Photonen zur Verfügung stehende Zeit um die Anzahl der Pixel eines Zeilenarrays multipliziert wird. Es lässt sich eine komplette Zeile eines Bildes mit großer Empfindlichkeit und mit gegenüber herkömmlichen CCD-Arrays erheblich verringertem Rauschen auslesen. Auch einzelne Photonen können detektiert werden. Zudem lässt sich die Ansteuerschaltung derart realisieren, dass, im Gegensatz zu herkömmlichen CCD-Arrays, alle Bildpunkte, d. h. alle Avalanche-Halbleiterdetektoren, gleichzeitig ausgelesen werden können. Dies erhöht die Aufnahmegeschwindigkeit erheblich.

Die Summierung der während einer vorgegebenen Zählzeit von den einzelnen Avalanche-Halbleiterdetektoren detektierten Lichtpulse kann auf verschiedene Weisen erfolgen. Diese Detektion kann beispielsweise durch einfaches Aufsummieren von Ladungen erfolgen, die dann gemeinsam ausgelesen werden. Besonders bevorzugt ist es jedoch, wie oben beschrieben, wenn einzelne Photonen detektiert werden, wobei die dabei von den Avalanche-Halbleiterdetektoren erzeugten Lichtsignale dann einzeln ausgelesen werden, um elektronisch in einem elektronischen Zähler summiert zu werden. Dieses Schema ermöglicht beispielsweise die Verwendung verschiedener Zählschemata, da zum Beispiel die Signale einzelner Detektoren addiert werden können. Alternativ ist jedoch mit dieser Anordnung auch, beispielsweise durch einen Benutzer wählbar, das Zählen einzelner Photonen möglich.

Der Parallelzähler kann insbesondere einen Analog/Digital-Wandler umfassen, um analoge Signale zu digitalisieren. Besonders bevorzugt ist es, alternativ oder zusätzlich, wenn der Parallelzähler mindestens einen FPGA und/oder mindestens einen CPLD umfasst. Ein FPGA (Field Programmable Gate Array) ist ein programmierbarer Halbleiterbaustein, welcher programmierbare logische Komponenten umfasst und welcher in der Regel als Matrix ausgestaltet ist. Es können Verbindungen zwischen diesen einzelnen logischen Komponenten im Wesentlichen frei programmiert werden, so dass beispielsweise nach Belieben oder nach Vorgabe eines Benutzers eines Mikroskops bestimmte Avalanche-Halbleiterdetektoren des Zeilenarrays logisch verknüpft werden können, beispielsweise durch eine "OR"-Verknüpfung.

Auf ähnliche Weise ist auch ein CPLD (Complex Programmable Logic Device), welches eine programmierbare Diodenmatrix aufweist, ein programmierbarer Logikbaustein, welcher für ähnliche Zwecke eingesetzt werden kann. Insbesondere können das FPGA und/oder das CPLD genutzt werden, um auf flexible und bequeme Weise den oben beschriebenen Parallelzähler zu realisieren. So können insbesondere das FPGA und/oder das CPLD derart programmiert sein, dass diese während der Zählzeit die detektierten Lichtpulse summieren. Auch andere Operationen können durchgeführt werden.

Ein Problem bekannter Avalanche-Halbleiterdetektoren besteht darin, dass zwischen einzelnen Zählpulsen vergleichsweise hohe "Totzeiten" auftreten können. Diese Totzeiten sind technisch insbesondere dadurch bedingt, dass durch die erzeugte "Ladungslawine", welche im Geiger-Modus auftritt, die hohe Sperrspannung für eine gewisse Zeit zusammenbricht, so lange, bis die Ladungswolke innerhalb des Halbleiterdetektors "gelöscht" ist und der Ausgangszustand, welcher für den Betrieb der APD erforderlich ist, wieder hergestellt ist. Die Totzeiten werden auch durch die externe Beschaltung bedingt, da ein erneutes Aufladen der APD nach einem Lichtpuls mit einer Verzögerung erfolgt, analog zu dem Trägheitsverhalten eines RC-Schaltkreises.

Erfindungsgemäß wird daher der Lichtdetektor mit mehreren Zeilenarrays ausgestaltet. Beispielsweise können zwei Zeilenarrays vorgesehen sein, wobei bei einem Zeilenscan einem Bildpunkt der Zeile zwei Bildpunkte auf den beiden Zeilenarrays zugeordnet sind, nämlich ein erster Avalanche-Halbleiterdetektor auf dem ersten Zeilenarray und ein zweiter Avalanche-Halbleiterdetektor auf dem zweiten Zeilenarray. Dies kann beispielsweise dadurch realisiert werden, dass die beiden Zeilenarrays parallel zueinander ausgerichtet sind, so dass der erste und der zweite Avalanche-Halbleiterdetektor in einer y-Richtung (senkrecht zur Längserstreckung der Zeilenarrays, welche mit x bezeichnet werden kann) angeordnet sind.

Dabei ist die Ansteuerschaltung eingerichtet, um die Summe der durch den ersten Avalanche-Halbleiterdetektor und durch den zweiten Avalanche-Halbleiterdetektor detektierten Lichtpulse zu erfassen.

Dieser Aspekt der Erfindung hat den Vorteil, dass die aktive Fläche eines Bildpunktes einer Bildzeile nunmehr verdoppelt wird und gleichzeitig in zwei (oder mehr, je nach Anzahl der Zeilenarrays) unabhängig auslesbare Teilbereiche unterteilt ist. Während der Totzeit eines Avalanche-Halbleiterdetektors ist mit hoher Wahrscheinlichkeit der zweite Avalanche-Halbleiterdetektor aktiv, so dass dieser weiterhin Photonen registrieren kann. Auf diese Weise wird das durch die Totzeiten auftretende Problem der Avalanche-Halbleiterdetektoren stark vermindert.

Die Addition der Signale der jeweils einander zugeordneten Avalanche-Halbleiterdetektoren auf dem ersten Zeilenarray und dem zweiten Zeilenarray (bzw. weiterer Zeilenarrays) kann auf verschiedene Weisen erfolgen. Zum einen kann diese Addition auf rein elektronische Weise erfolgen, beispielsweise indem elektronisch die Signale der einander zugeordneten Avalanche-Halbleiterdetektoren zu einem Summensignal addiert werden und anschließend auf einen gemeinsame Zähleingang des Parallelzählers gelegt werden. Dieser gemeinsame Zähleingang zählt dann bereits die Summe der registrierten Signale. Die elektronische Addition kann beispielsweise durch eine einfache Stromaddition erfolgen.

Alternativ oder zusätzlich kann die Addition der Signale der einander zugeordneten Avalanche-Halbleiterdetektoren auch durch logische Bauelemente oder softwaretechnisch realisiert werden. Besonders bevorzugt ist es dabei, wenn zu diesem Zweck der Parallelzähler verwendet wird. Beispielsweise können hierfür die Signale der einander zugeordneten einzelnen Avalanche-Halbleiterdetektoren der verschiedenen Zeilenarrays auf getrennte Signaleingänge des Parallelzählers geschaltet werden, wobei der Parallelzähler eingerichtet ist (beispielsweise durch entsprechende Programmierung der logischen Bauelemente), um die Signale der einander zugeordneten Avalanche-Halbleiterdetektoren zu addieren.

Insbesondere kann der Parallelzähler für einen der oben beschriebenen Additions- oder Zählvorgänge einen Speicherbereich mit mehreren Speicherzellen umfassen. Dabei können diese Speicherzellen einzelnen Avalanche-Halbleiterdetektoren der Zeilenarrays bzw. eines Zeilenarrays zugeordnet sein. Diese Speicherzellen können mit vorgegebenen Werten belegt sein (beispielsweise mit einem vorgegebenen Wert "1"). Diese vorgegebenen Werte entsprechen einem Ruhezustand, in welchem keine Signale detektiert sind. Dann kann die Ansteuerschaltung eingerichtet sein, um den Wert einer Speicherzelle kurzfristig zu erhöhen oder zu erniedrigen, wenn ein oder mehrere dieser Speicherzelle zugeordnete Avalanche-Halbleiterdetektoren einen Lichtpuls detektieren. Beispielsweise kann im Falle der Detektion eines einzelnen Photons der Wert der Speicherzelle, welche dem Avalanche-Halbleiterdetektor zugeordnet ist, der das Photon detektiert hat, kurzfristig vom Wert "1" auf den Wert "0" heruntergesetzt werden. Beispielsweise kann dann der String der Werte der Speicherzellen, welcher ausgelesen werden kann, der Bildinformation des Zeilendetektors entsprechen. Auch Additionen lassen sich auf diese Weise einfach vornehmen, indem beispielsweise die Bit-Strings des Zeilenarrays, welche während der Zählzeit registriert wurden, entsprechend addiert werden. Auch die Addition mehrerer Zeilenarrays, beispielsweise zweier parallel angeordneter Zeilenarrays, beziehungsweise die Addition der dabei einander zugeordneten einzelnen Avalanche-Halbleiterdetektoren eines Bildpunkts einer Zeile lässt sich auf diese Weise leicht realisieren. Nach der Detektion und/oder mit einer vorgegebenen Auslese-Taktrate lassen sich dann die Werte der Speicherzellen wieder auf die ursprünglichen vorgegebenen Werte zurücksetzen, so dass erneut gezählt werden kann.

Weiterhin kann der Lichtdetektor eine Vielzahl von Mikrolinsen umfassen, welche eingerichtet sind, um auftreffendes Licht auf jeweils einem oder mehreren Avalanche-Halbleiterdetektoren zu bündeln. Diese Weiterbildung macht sich insbesondere positiv bemerkbar, wenn einem Bildpunkt einer Zeile mehrere Avalanche-Halbleiterdetektoren zugeordnet sind, beispielsweise im Fall von zwei parallel angeordneten Zeilenarrays. In diesem Fall können beispielsweise Mikro-Zylinderlinsen eingesetzt werden, um jeweils zwei einander zugeordnete Avalanche-Halbleiterdetektoren gleichmäßig zu beleuchten.

Zusätzlich zu der oben beschriebenen Verwendung mehrerer Zeilenarrays, insbesondere zweier Zeilenarrays, um die Auswirkung der Totzeiten der einzelnen Avalanche-Halbleiterdetektoren zu vermindern, können auch die einzelnen Avalanche-Halbleiterdetektoren geeignet beschaltet werden, um den Effekt der Totzeit bzw. die Totzeit weiter zu reduzieren. Derartige Beschaltungen sind aus dem Stand der Technik bekannt und beruhen im Wesentlichen auf einer durch einen Lichtpuls ausgelösten Impedanzanpassung der Beschaltung der APD. Durch diese kurzfristige Impedanzanpassung wird erreicht, dass die Aufladung der APD und die Wiederherstellung des Ausgangszustandes nach dem Registrieren eines Photons und der dadurch verursachten Erzeugung einer Ladungswolke beschleunigt werden. Dieser Vorgang wird auch als "Quenching" (Löschen) bezeichnet, und die aktive Ausnutzung dieses Effekts als "Active Quenching". Der wesentliche Trick dieser Beschaltung besteht darin, dass der die Aufladezeit im Wesentlichen begrenzende Messwiderstand, welcher in Serie mit der APD geschaltet ist, nach Registrieren des Ladungspulses (ggf. mit einer vorgegebenen Verzögerung) durch eine Transistorschaltung (oder eine andere Art der Schaltung) kurzfristig kurzgeschlossen oder niederohmig geschaltet wird, so dass beispielsweise ein Schaltungspunkt hinter der APD durch einen Transistorschalter kurzfristig auf Masse gelegt wird oder ein Widerstand im RC-Kreis der APD überbrückt wird, so dass insgesamt die RC-Konstante der Wiederaufladung der APD erheblich gesenkt wird. Das Schalten dieses Transistorschalters kann über einen entsprechenden Verzögerungsbaustein, getriggert beispielsweise durch das von der APD erzeugte Signal selbst, erfolgen. Ein Beispiel einer derartigen Schaltung ist in US 5,532,474 dargestellt. Auch andere Arten der aktiven Löschung sind jedoch möglich und im Rahmen der vorliegenden Erfindung realisierbar.

Wie oben beschrieben, lässt sich der vorgeschlagene Lichtdetektor insbesondere in einem Scanmikroskop einsetzen. Es wird dementsprechend auch ein Mikroskop vorgeschlagen, welches eine Lichtquelle zur Beleuchtung einer Probe aufweist, eine Scanvorrichtung zum Abtasten der Probe mit einem oder mehreren von der Lichtquelle ausgehenden Lichtstrahlen, sowie weiterhin einen Lichtdetektor gemäß einer der oben beschriebenen Ausgestaltungen. Der Lichtdetektor ist dabei derart in dem Mikroskop angeordnet, dass dieser von der Probe emittiertes und/oder transmittiertes und/oder reflektiertes Licht (je nach Messanordnung) detektiert. Das Mikroskop kann insbesondere als Konfokalmikroskop ausgestaltet sein. Vorzugsweise ist das Scanmikroskop ein Linienscan-Mikroskop, bei welchem die Probe mittels des von der Lichtquelle ausgehenden Lichtstrahls zeilenweise abgetastet wird. In diesem Fall kann insbesondere, wie oben beschrieben, ein Zeilenarray mit den einzelnen Avalanche-Halbleiterdetektoren gerade einer Bildzeile entsprechen.

Insbesondere kann das Mikroskop ein oder mehrere Strahlteiler-Elemente umfassen, beispielsweise um Anregungs- und Detektionslicht zu trennen. In einer vorteilhaften Ausgestaltung wird dabei ein räumlich trennender Stahlteiler verwendet, welcher von der Probe ausgehendes (d. h. von dieser emittiertes, transmittiertes oder reflektiertes) kohärentes Licht von von der Probe ausgehendem inkohärentem Licht trennt. Ein derartiger räumlicher Strahlteiler ist beispielsweise in DE 102 57 237 oder DE 198 42 153 C2 beschrieben. Der räumliche Strahlteiler kann beispielsweise mindestens zwei Bereiche mit unterschiedlichen Transmissionseigenschaften aufweisen, wobei mindestens ein erster Bereich mit hoher Transmission und mindestens ein zweiter Bereich mit hoher Reflektivität umfasst ist. Beispielsweise kann es sich hierbei um (teil-)verspiegelte Bereiche handeln, mit einem für die jeweiligen Wellenlängen transparenten Trägersubstrat.

Die Funktionsweise des räumlich trennenden Strahlteilers beruht im Wesentlichen auf der Tatsache, dass kohärente Detektionslichtanteile wieder in die definierten Bereiche des räumlich trennenden Strahlteilers abgebildet werden, während inkohärente Lichtteile vorzugsweise im Wesentlichen die volle Pupille ausstrahlen. Ursächlich hierfür ist, dass ein kohärentes Signal von dem Probenraum in der Pupillenebene des räumlichen Strahlteilers so interferiert, dass es dort dieselbe Struktur erzeugt wie das zuvor eingestrahlte Beleuchtungssignal. Ein inkohärentes Signal setzt sich jedoch aus einer Vielzahl unabhängiger Punktstrahler zusammen, von denen jeder einzelne die volle Pupillenebene des räumlich trennenden Strahlteilers beleuchtet. Die Summe aller Punktstrahler leuchtet damit ebenfalls die volle Pupillenebene aus. Dieser Effekt wird bei der Trennung des von der Probe ausgesandten Detektionslichtes in einen kohärenten Anteil und einen inkohärenten Anteil ausgenutzt. Die Trennung erfolgt mit hoher Effizienz, hohem Unterdrückungsverhältnis und ist kostengünstig realisierbar.

Beispielsweise kann der oben beschriebene verspiegelte Bereich in Form eines schmalen spiegelnden Streifens auf einem Träger (beispielsweise einem Glasplättchen) ausgestaltet sein. Dies ist insbesondere für die Verwendung in einem Zeilenscanmikroskop für die Fluoreszenzmikroskopie von Vorteil. Hierbei kann der räumliche Strahlteiler beispielsweise derart genutzt werden, dass kohärentes Anregungslicht über den streifenförmigen verspiegelten Bereich auf die Probe gelenkt wird, wohingegen inkohärentes Fluoreszenzlicht im Wesentlichen auf dem entgegengesetzten Weg den Strahlteiler passiert und zu einem Lichtdetektor der oben beschriebenen Art mit mindestens einem Zeilenarray gelangt.

Der oben beschriebene Lichtdetektor mit dem mindestens einen Zeilenarray mit der Vielzahl von Avalanche-Halbleiterdetektoren lässt sich in einem Scanmikroskop vorteilhaft auch derart ausgestalten, dass unterschiedliche spektrale Wellenlängenbereiche eines einzelnen Bereichs einer Probe auf unterschiedliche Avalanche-Halbleiterdetektoren des Zeilenarrays bzw. des Lichtdetektors abgebildet werden. Besonders vorteilhaft macht sich dies bemerkbar, wenn zwei Zeilenarrays eingesetzt werden. Es kann beispielsweise ein spektrales Trennelement vorgesehen sein, welches Bildinformationen einer Zeile der Probe spektral auftrennt in mindestens zwei Wellenlängenbereiche. Diese mindestens zwei Wellenlängenbereiche können dann auf unterschiedliche Avalanche-Halbleiterdetektoren des Lichtdetektors abgebildet werden. Beispielsweise kann ein erster Wellenlängenbereich auf ein erstes Zeilenarray abgebildet werden, wohingegen ein zweiter Wellenlängenbereich auf ein zweites Zeilenarray abgebildet wird. In diesem Fall können mit hoher Geschwindigkeit nicht nur Bildinformationen eines Wellenlängenbereichs, sondern gleichzeitig Bildinformationen mehrerer Wellenlängenbereiche aufgenommen werden, wodurch beispielsweise der Kontrast oder andere Bildeigenschaften positiv beeinflusst werden können. Beispielsweise kann das Mikroskop derart eingerichtet sein, dass ein erstes Zeilenarray Bildinformationen in einem spektralen Bereich aufnimmt, in welchem ein erster Peak eines Fluoreszenzfarbstoffs der Probe liegt, wohingegen ein zweites Zeilenarray Informationen in einem Bereich um einen zweiten Peak eines Fluoreszenzfarbstoffs der Probe aufnimmt. Zur spektralen Trennung können verschiedene bekannte spektral trennende Elemente eingesetzt werden, beispielsweise Gitter und/oder Prismen. Auch bei dieser bevorzugten Anordnung macht sich der vorgeschlagene hochempfindliche und schnell auslesbare Lichtdetektor besonders vorteilhaft bemerkbar, da gleichzeitig und mit höchster Empfindlichkeit Bildinformationen in verschiedenen Wellenlängenbereichen aufgenommen werden können.

### Ausführungsbeispiele der Erfindung

Weitere Einzelheiten und Merkmale der Erfindung ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Erfindung ist nicht auf die Ausführungsbeispiele beschränkt. Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

Im Einzelnen zeigen:
- Figuren 1A und 1B: ein nicht unter den Schutzumfang der Erfindung fallendes Beispiel eines Lichtdetektors mit einem Zeilenarray;
- Figur 1C: ein weiteres Beispiel einer Active-Quenching-Schaltung für eine APD des Zeilenarrays gemäß den Figuren 1A und 1B;
- Figuren 2A und 2B: ein Ausführungsbeispiel eines Lichtdetektors mit zwei Zeilenarrays in dem erfindungsgemäßen Zeilenscanmikroskop;
- Figur 3: ein erstes erfindungsgemäßes Ausführungsbeispiel eines Zeilenscanmikroskops mit einem räumlichen Strahlteiler und einem erfindungsgemäßen Lichtdetektor;
- Figur 4: ein zweites Ausführungsbeispiel eines Zeilenscanmikroskops mit zusätzlich einem dicroitischen Strahlteiler im Detektionsstrahlengang; und
- Figur 5: ein drittes Ausführungsbeispiel eines Zeilenscanmikroskops mit einem Prisma im Detektionsstrahlengang.

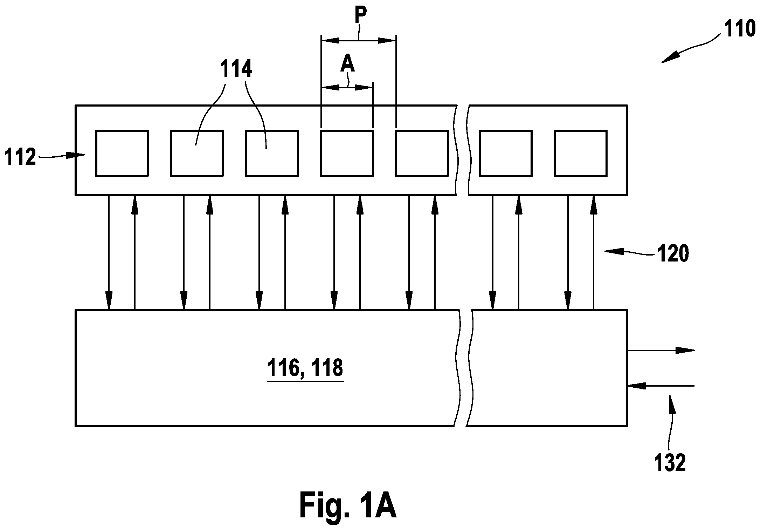

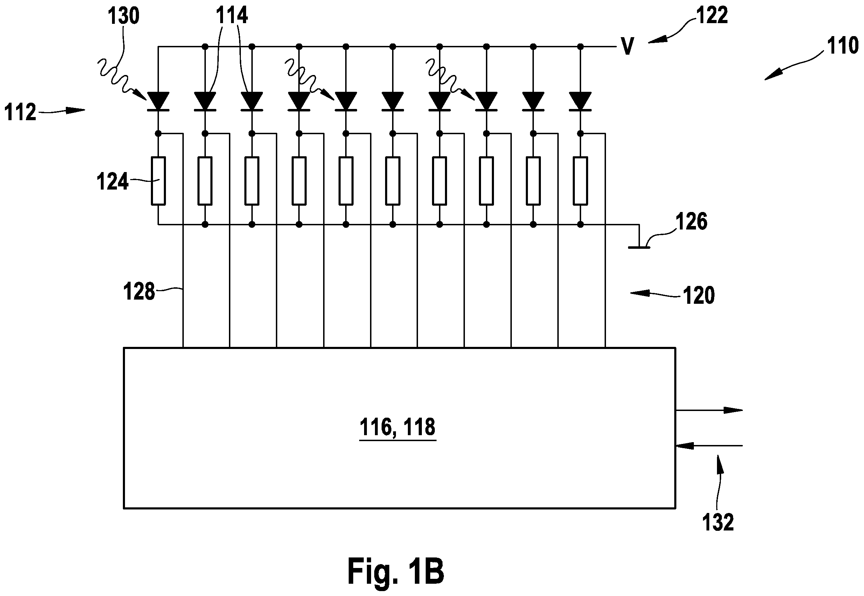

In den Figuren 1A und 1B ist ein erstes Beispiel eines Lichtdetektors 110 dargestellt. Dabei zeigt Figur 1A den äußeren Aufbau des Lichtdetektors 110, wohingegen Figur 1B schematisch die elektrische Beschaltung des Lichtdetektors 110 verdeutlichen soll.

Der Lichtdetektor 110 weist in dem in Figur 1A dargestellten Beispiel ein Zeilenarray 112 auf, welches in diesem Beispiel als monolithisches Halbleiterbauelement ausgestaltet ist und eine Vielzahl von in einer Reihe angeordneten Avalanche-Halbleiterdetektoren 114 (im Folgenden auch als APDs bezeichnet) aufweist. Das Zeilenarray 112 weist einen Pitch auf, welcher in Figur 1A mit P bezeichnet ist und welcher beispielsweise bei 150 µm liegt. Der aktive Anteil, welcher dabei auf die aktiven Flächen der APDs 114 entfällt, ist in Figur 1A mit A bezeichnet. Dabei ergibt sich ein linearer Füllfaktor A/P, welcher beispielsweise bei 50 Prozent oder mehr liegen kann.

Für den Aufbau des Zeilenarrays 112 kann auf dem Fachmann bekannte Halbleitertechniken verwiesen werden, beispielsweise das in US 4,458,260 beschriebene Verfahren. Beispielsweise kann es sich bei den APDs 114 um Single Photon-APDs (SPADs) handeln, welche auf der Basis von InGaAs/InP aufgebaut sind und welche sowohl im linearen Modus als auch im Geiger-Modus betrieben werden können.

Vorzugsweise weist das Zeilenarray 112 mindestens 256 einzelne Bildpunkte in Form von APDs 114 auf, vorzugsweise jedoch mehr. Typischerweise sind 512 bis 1.024 Bildpunkte vorgesehen.

Weiterhin umfasst der Lichtdetektor 110 eine Ansteuerschaltung 116. Diese Ansteuerschaltung, welche in den Figuren 1A und 1B lediglich schematisch dargestellt ist, umfasst insbesondere einen Parallelzähler 118, welcher beispielsweise einen FPGA und/oder einen CPLD umfassen kann. Die Ansteuerschaltung 116 ist über eine Vielzahl von parallelen Verbindungsleitungen 120 mit dem Zeilenarray 112 verbunden, so dass jede APD 114 parallel angesteuert und/oder ausgelesen werden kann.

Anstelle des getrennten Aufbaus von Ansteuerschaltung 116 und Zeilenarray 112, wie in Figur 1A und Figur 1B, ist jedoch auch eine integrierte Bauweise des Lichtdetektors 110 möglich. Beispielsweise können das Zeilenarray 112 und die Ansteuerschaltung 116 ebenfalls monolithisch in einen einzelnen Halbleiterchip integriert sein.

In Figur 1B ist schematisch die Beschaltung des Zeilenarrays 112 dargestellt. Jede APD 114 wird mit einer Vorspannung V beaufschlagt und ist über einen Messwiderstand 124 mit einer Masse 126 verbunden. Über Messleitungen 128, welche Bestandteil der Verbindungsleitungen 120 sind, wird eine über den Messwiderständen 124 abfallende Spannung abgegriffen, wobei jede Messleitung 128 mit einem Eingang der Ansteuerschaltung 116 bzw. des Parallelzählers 118 verbunden ist. Zusätzlich können (in Figur 1B nicht dargestellt) noch Analog-Digital-Wandler vorgesehen sein, welche die analogen Spannungssignale in Digitalsignale umwandeln, welche dann vom Parallelzähler 118 gezählt werden können.

Vorzugsweise sind die APDs 114 derart beschaltet (zum Beispiel durch Wahl einer entsprechenden Vorspannung 122, welche oberhalb der Durchbruchspannung der APDs 114 liegt), dass jedes einzelne Photon (in Figur 1B symbolisch mit Bezugsziffer 130 bezeichnet) einen Puls auslöst, welcher vom Parallelzähler 118 gezählt werden kann.

Der Lichtdetektor 110 erfüllt die Voraussetzungen für den Einsatz in einem Scanmikroskop, insbesondere einem Laserscanmikroskop, insbesondere einem konfokalen Laserscanmikroskop, in hervorragender Weise. Insbesondere wird das Zeilenarray 112 den Anforderungen, welche die parallelisierte Probenbeleuchtung bei einem Zeilenscanmikroskop stellt, hervorragend gerecht, da eine parallelisierte Detektionsmöglichkeit besteht. Das Zeilenarray 112 kann mit einer Auslesegeschwindigkeit ausgelesen werden, welche hinreichend schnell ist. Insbesondere können dabei Videoraten verwendet werden, beispielsweise 30 Bilder pro Sekunde, also mindestens 16 k Zeilen pro Sekunde oder vorzugsweise mehr als 60 k Zeilen pro Sekunde.

Unter den eingangs beschriebenen Annahmen, also 1.024 Punkten pro Zeile, 16 k Zeilen pro Sekunde, ergebe sich für ein Signal-zu-Rausch-Verhältnis von 20 (d. h. 400 Photonen pro Pixel, Schrotrauschen) und eine Belichtungszeit von 62,5 µs pro Zeile eine Anzahl von 6,4 · 10⁶ detektierten Photonen pro Sekunde. Dies bedeutet, dass in der Probe 1,024 · 10⁸ Photonen pro Sekunde generiert werden müssen, was bei der genannten Lebensdauer von 5 · 10⁻⁹ s mit einem einzelnen Farbstoffmolekül erreicht werden kann. Zum einen wird, im Vergleich zu einem Punktscanner, die zur Verfügung stehende Zeit um die Anzahl der Pixel des Zeilenarrays 112 multipliziert, und zum anderen verlängert sich die Zeit durch einen Nutzzyklus (Duty Cycle) von annähernd 100 Prozent bei dem Zeilenscanner mit dem in Figur 1A und in Figur 1B dargestellten Lichtdetektor 110. Dies ist insbesondere darauf zurückzuführen, dass bei einem Punktscanner aufgrund des sinusförmigen Scanvorgangs für mindestens die Hälfte der Zeit keine Daten erfasst werden können.

Die Auslesung und Auswertung der Daten des Lichtdetektors 110 kann mit der in den Figuren 1A und 1B vorgeschlagenen Anordnung parallel für alle APDs 114 mittels des CPLDs bzw. FPGAs erfolgen. Dazu werden die APDs 114, wie oben dargestellt, bevorzugt im Einzel-Photonen-Zähl-Modus (Geiger-Mode) betrieben, und die Anzahl der Ereignisse pro Zeilendauer (d. h. für eine einzelne Zeile des Bildes zur Verfügung stehende Zählzeit) aufsummiert.

Neben dem Betrieb im Geiger-Modus wäre auch ein Betrieb im linearen Modus denkbar, in welchem das APD-Signal direkt proportional ist zur Beleuchtungsintensität. In diesem Fall wäre die Vorspannung 122 entsprechend anzupassen.

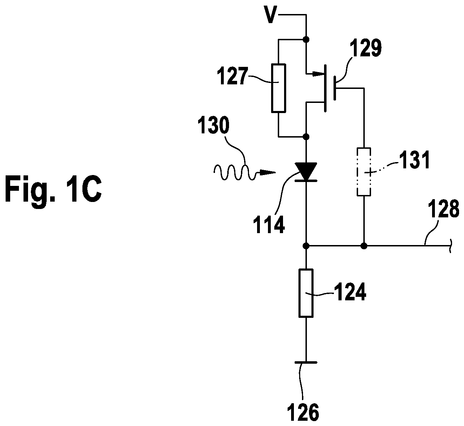

Zur Reduktion der Totzeiten können die einzelnen APDs, wie oben beschrieben, zusätzlich mit einer Active Quenching-Schaltung ausgestattet werden. Ein Beispiel einer derartigen Beschaltung ist in Figur 1C dargestellt. Die Schaltung in Figur 1B lässt sich leicht durch die in Figur 1C für eine einzelne APD 114 dargestellte Schaltung ergänzen.

Wiederum wird in Figur 1C jede der APDs 114 des Zeilenarrays 112 mit einer Vorspannung V beaufschlagt. In diesem Fall ist noch ein Vorwiderstand 127 zwischen APD 114 und Vorspannungsquelle V vorgesehen, welcher auch in Figur 1B optional ergänzbar ist. Parallel zum Vorwiderstand 127 ist ein Transistorschalter 129 geschaltet. Wird dieser Transistorschalter 129 geschlossen, so ist der Vorwiderstand 127 überbrückt, so dass die RC-Zeitkonstante der Wiederaufladung der APD 114 durch den verkleinerten Ohmschen Widerstand (nunmehr nur noch der ohmsche Widerstand des Messwiderstands 124 anstelle der Summe der Ohmschen Widerstände 127 und 124) erheblich verringert ist. Dadurch lässt sich die Totzeit der APD 114 aktiv verkürzen.

Die Schaltung des Transistorschalters 129 erfolgt durch das von der APD 114 erzeugte Signal, welches an der der APD 114 zugeordneten Messleitung 128 abgegriffen wird. Die Messleitung 128 ist daher mit der Basis des Transistorschalters 129 verbunden. Ein Spannungspuls am Messwiderstand 124 schaltet daher den Transistorschalter 129, so dass die aktive Löschung durchgeführt wird. Zusätzlich kann, optional, zwischen Messleitung 128 und der Basis des Transistorschalters 129 noch ein Delay 131 geschaltet werden, welches die Schaltung des Transistorschalters 129 verzögert (beispielsweise um einige Mikrosekunden oder, bevorzugt, um wenige Nanosekunden). Auf diese Weise wird bewirkt, dass die Löschung erst durchgeführt wird, nachdem die APD ein für den Parallelzähler 118 zählbares Signal geliefert hat.

Das Auslesen des Zeilenarrays 112 in den Figuren 1A und 1B wird vorzugsweise durch die Ansteuerschaltung 116 mit dem Scanvorgang eines Mikroskops synchronisiert. Diese Synchronisation kann beispielsweise über eine Schnittstelle 132 erfolgen, welche beispielsweise Trigger-Signale von einer Mikroskopsteuerung empfängt, beispielsweise die oben genannte Zählzeit, welche für eine Bildzeile einer Probe zur Verfügung steht.

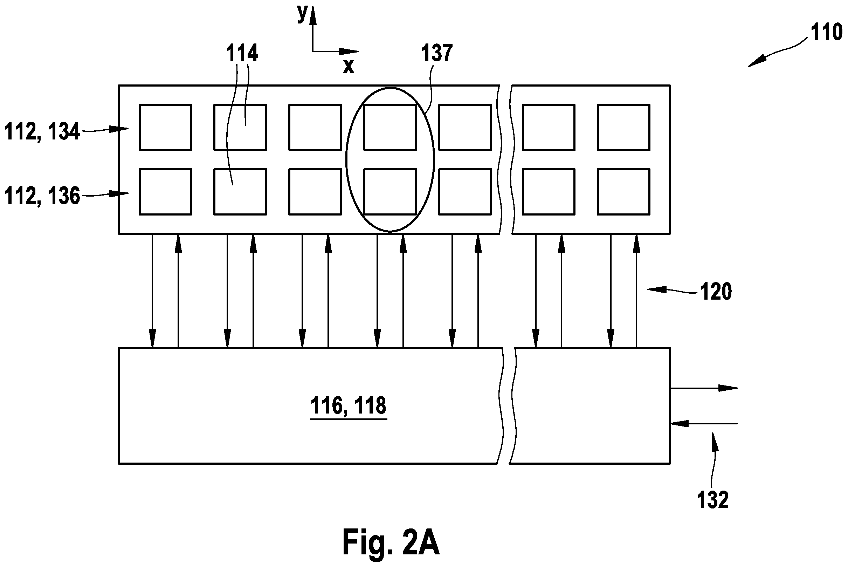

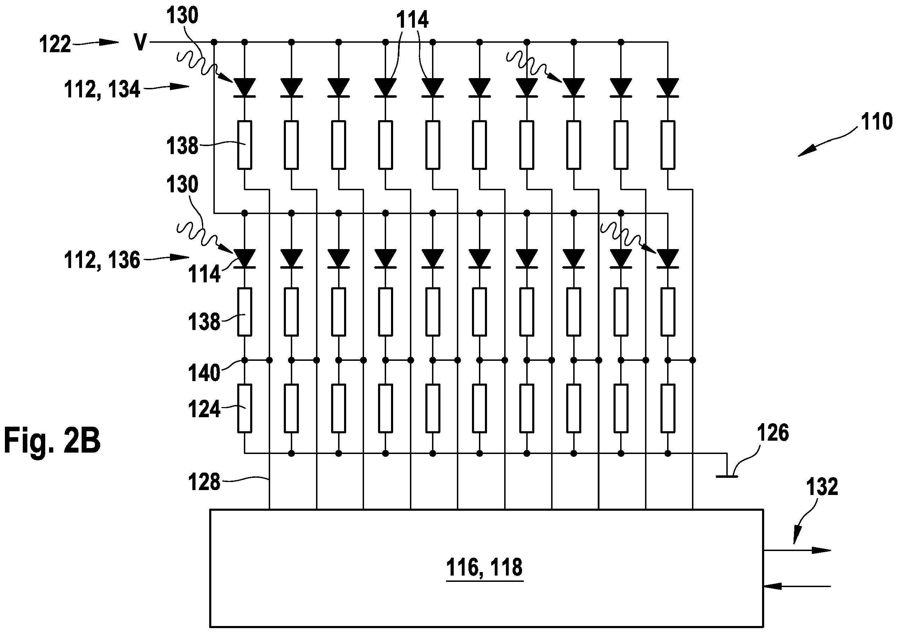

In dem Beispiel gemäß den Figuren 1A und 1B weist der Lichtdetektor 110 ein einzelnes Zeilenarray 112 auf. In den Figuren 2A und 2B ist demgegenüber ein Ausführungsbeispiel eines Lichtdetektors in dem erfindungsgemäßen Zeilenscanmikroskop dargestellt, bei welchem der Lichtdetektor 110 zwei parallele Zeilenarrays 134, 136 aufweist. Beide Zeilenarrays 134, 136 sind als einzelnes monolithisches Halbleiterbauelement ausgestaltet, analog zur Ausgestaltung in Figur 1A. Dabei sind in dem in Figur 2A dargestellten Beispiel die einzelnen APDs 114 der Zeilenarrays 134, 136 derart parallel angeordnet, dass jeweils eine APD 114 des ersten Zeilenarrays 134 und eine APD 114 des zweiten Zeilenarrays 136 gleiche x-Koordinaten (d. h. Koordinaten in einer Richtung parallel zur Längserstreckung der Zeilenarrays 134, 136) aufweisen. Diese APDs 114 mit gleicher x-Koordinate, welche sich lediglich in der senkrecht dazu ausgerichteten y-Koordinate unterscheiden, sind jeweils einander zugeordnet und sind, bei einem Zeilenscanmikroskop, einem gemeinsamen Bildpunkt einer Zeile der Probe zugeordnet. Jeweils zwei einander zugeordnete APDs 114 können beispielsweise über eine gemeinsame Mikrolinse 137 verfügen, welche in Figur 2A in einem Fall angedeutet ist. Diese Mikrolinse 137 kann beispielsweise als Zylinderlinse ausgestaltet sein und kann für eine Verteilung der Lichtintensität auf die beiden APDs 114 sorgen. Die Mikrolinsen können beispielsweise nach Erzeugung eines monolithischen Lichtdetektors 110 als Kunststofflinsen (beispielsweise durch ein Druckverfahren) auf die Zeilenarrays 112 aufgebracht werden.

Das in Figur 2A dargestellte Ausführungsbeispiel stellt nur ein Ausführungsbeispiel eines erfindungsgemäßen Lichtdetektors 110 dar, bei welchem das eindimensionale Zeilenarray 112 gemäß Figur 1A auf eine zweite Dimension erweitert wird, so dass mehrere Bildpunkte in Form von APDs 114 pro Pixel einer Zeile der Probe zur Verfügung stehen. Es sind auch alternative Ausführungsformen denkbar, beispielsweise mit mehreren parallel angeordneten Zeilenarrays 112, oder Anordnungen, bei denen einander zugeordnete APDs 114 nicht exakt dieselbe x-Koordinate aufweisen, sondern beispielsweise leicht versetzt angeordnet sind.

Auch im Fall des Ausführungsbeispiels gemäß den Figuren 2A und 2B ist wiederum eine parallele Auslesung der Zeilenarrays 134 und 136 von Vorteil. Dabei können jeweils einander zugeordnete APDs 114 entweder separat ausgelesen werden oder ein Summensignal dieser APDs 114 kann ausgelesen werden. Anschließend werden diese Signale in dem Parallelzähler 118 während der vorgegebenen Zählzeit gezählt. Werden separate Signale von einander zugeordneten APDs 114 auf den Parallelzähler 118 gegeben, so kann dieser beispielsweise die Summierung dieser Signale der einander zugeordneten APDs 114 übernehmen.

In Figur 2B ist demgegenüber eine Beschaltung dargestellt, bei welcher der Parallelzähler 118 bereits mit einem Summensignal beaufschlagt wird. Dabei ist die Schaltung ähnlich aufgebaut wie im Beispiel gemäß Figur 1B, wobei jedoch, wie oben beschrieben, zwei Zeilenarrays 134, 136 mit jeweils paarweise einander zugeordneten APDs 114 vorgesehen sind. Jeder APD ist ein Vorwiderstand 138 in Reihe geschaltet. Anschließend werden die jeweils einander zugeordneten APDs paarweise an Knotenpunkten 140 miteinander verbunden, wobei diese Knotenpunkte 140, analog zu Figur 1B, über Messwiderstände 124 mit der Masse 126 verbunden sind. Über Messleitungen 128 wird das über den Messwiderständen 124 abfallende Signal abgegriffen, und die Pulse, welche einzelnen Photonen 130 entsprechen, im Parallelzähler 118 werden gezählt. An den Knotenpunkten 140 in dem Ausführungsbeispiel gemäß Figur 2B findet somit eine Addition der einzelnen Messströme der APDs 114 statt.

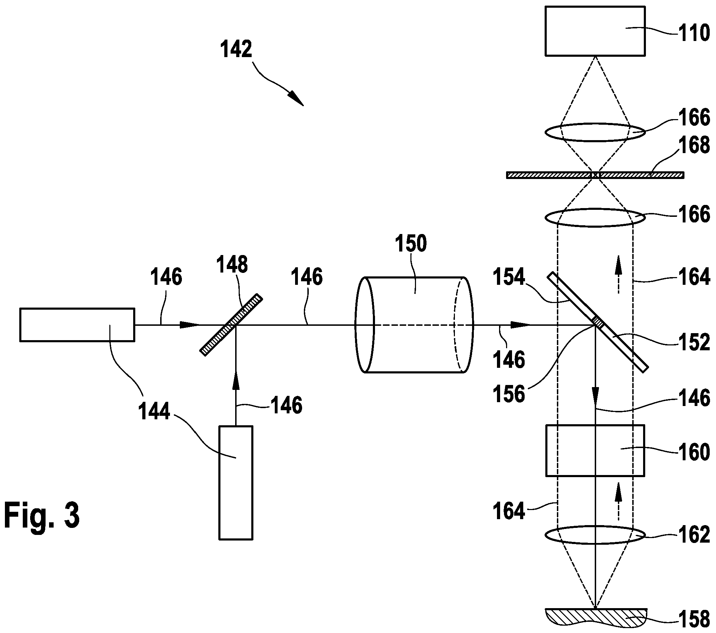

Auch die Schaltung in Figur 2B ist wiederum ergänzbar durch eine Active-Quenching-Schaltung, beispielsweise analog zur Schaltung in Figur 1C. Beispielsweise kann jeweils parallel zum Vorwiderstand 138 ein Transistorschalter 129 vorgesehen werden, um den Vorwiderstand 138 kurzfristig zu überbrücken. In Figur 3 ist ein Ausführungsbeispiel eines erfindungsgemäßen Scanmikroskops 142 dargestellt. Das Scanmikroskop ist in diesem Fall als Laserscanmikroskop ausgestaltet und weist zwei Laser-Lichtquellen 144 auf. Alternativ oder zusätzlich können weitere Lichtquellen vorgesehen sein, oder es kann auch ein Ausführungsbeispiel mit einem einzelnen Laser 144 realisiert werden. Anstelle von Lasern lassen sich grundsätzlich auch andere Lichtquellen einsetzen.

Die Anregungsstrahlen 146 der Laser-Lichtquellen 144 werden in einem Strahlteiler 148 (welcher in Figur 3 lediglich symbolisch dargestellt ist und auf verschiedene Weise realisiert werden kann) überlagert und in einer Strahlformung 150 (in Figur 3 ebenfalls lediglich schematisch dargestellt) geformt. Beispielsweise kann auf diese Weise eine linienförmige Beleuchtung erzeugt werden.

Die derart geformten Anregungsstrahlen 146 werden auf einen räumlich trennenden Strahlteiler 152 gelenkt. Dieser räumlich trennende Strahlteiler 152 ist in dem vereinfachten Ausführungsbeispiel gemäß Figur 3 lediglich schematisch dargestellt und weist Bereiche 154 mit geringer Reflektivität und hoher Transmission auf, sowie einen (in diesem Beispiel zentral angeordneten) Bereich 156 mit hoher Reflektivität. Beispielsweise kann dieser Bereich 156 als zentraler, schmaler Streifen auf einer Glasplatte ausgestaltet sein, beispielsweise ein Streifen mit einer Breite von nicht mehr als 1 bis 2 mm. Der Strahlengang und die Strahlformung 150 sind dabei derart ausgestaltet, dass vorzugsweise die Anregungsstrahlen 146 auf diesen Bereich 156 mit hoher Reflektivität fokussiert werden.

Von dem Bereich 156 mit der hohen Reflektivität werden die Anregungsstrahlen 146 dann zu einer Probe 158 gelenkt, dabei passieren die Anregungsstrahlen 146 eine Scaneinrichtung 160, welche beispielsweise eine x- und/oder y-Scaneinrichtung in Form von Galvanometerspiegeln umfassen kann. Auf diese Weise kann bei einem Punktscan beispielsweise die Position des Auftreffens der Anregungsstrahlen 146 auf der Oberfläche der Probe 158 eingestellt und die Probe auf diese Weise abgerastert werden. Bei einem Zeilenscan, bei welchem der Anregungslichtstrahl einen zeilenförmigen Querschnitt aufweist, kann die Probe 158 zeilenweise abgescannt werden. Derartige Scaneinrichtungen 160 sind aus dem Stand der Technik bekannt.

Weiterhin passieren die Anregungsstrahlen 146 auf ihrem Weg zur Probe 158 ein Objektiv 162. Insgesamt ist das in Figur 3 dargestellte Scanmikroskop 142 in konfokaler Bauweise ausgestaltet, wobei dasselbe Objektiv 162 sowohl für die Strahlformung der Anregungsstrahlen 146 als auch für die Strahlformung des Detektionslichts 164 genutzt wird.

Mit der in Figur 3 dargestellten Anordnung lässt sich beispielsweise Fluoreszenzspektroskopie betreiben, wobei die Anregungsstrahlen 146 die Probe 158 lokal zur Fluoreszenz anregen. Entsprechend sendet die Probe 158, welche mit dem kohärenten Laserlicht der Laserlichtquellen 144 angeregt wird, inkohärentes Fluoreszenzlicht als Detektionslicht 164 aus. Dies bedeutet, dass die angeregten Bildpunkte auf bzw. in der Probe 158 als einzelne, inkohärente Punktstrahler im Wesentlichen in alle Raumrichtungen emittieren. Dementsprechend wird der überwiegende Anteil des Detektionslichts 164, welches in Figur 3 gestrichelt dargestellt ist, nicht auf dem hochreflektierenden Bereich 156 des räumlich trennenden Strahlteilers 152 auftreffen, sondern die Bereiche 154 mit geringer Reflektivität passieren. Nur ein geringer Anteil des Detektionslichts 164 wird daher zurück zu den Laserlichtquellen 144 reflektiert.

Nach Transmission durch den räumlich trennenden Strahlteiler 152 wird das Detektionslicht 164 durch verschiedene Linsensysteme 166 (in Figur 3 lediglich symbolisch angedeutet) geformt und passiert eine Blende 168, welche ein wesentliches Element der konfokalen Anordnung darstellt. Diese Blende 168 bestimmt im Wesentlichen die räumliche Tiefe der Beobachtung innerhalb der Probe 158.

Nach Passieren der Linsensysteme 166 und der Blende 168, welche im Focus zwischen den Linsensystemen 166 angeordnet ist, gelangt das Detektionslicht auf den Lichtdetektor 110. Dieser Lichtdetektor 110 kann beispielsweise analog zu den Beispielen und Ausführungsbeispielen in den Figuren 1A und 1B oder 2A und 2B ausgestaltet sein. Hierbei macht sich, wie oben beschrieben, insbesondere vorteilhaft bemerkbar, dass Bildinformationen einer gesamten Bildzeile der Probe 158 parallel durch das Zeilenarray 112 ausgelesen werden können.

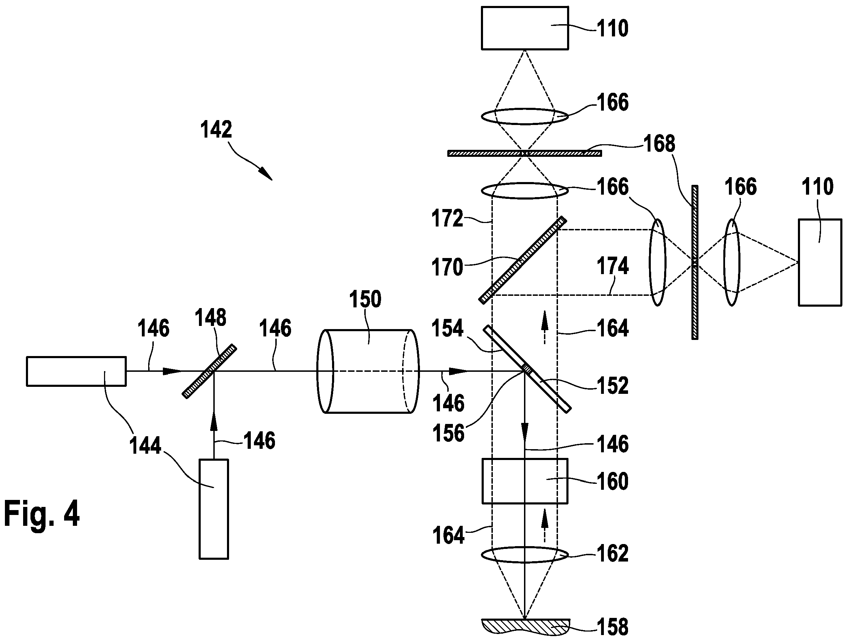

In Figur 4 ist ein zweites Ausführungsbeispiel eines erfindungsgemäßen Scanmikroskops 142 dargestellt, welches den erfindungsgemäßen Lichtdetektor 110 auf vorteilhafte Weise einsetzt. Bezüglich des Anregungs-Strahlenganges zur Erzeugung der Anregungsstrahlen 146 unterscheidet sich dieses Ausführungsbeispiel vorzugsweise nicht von dem in Figur 3 dargestellten Ausführungsbeispiel, so dass bezüglich der dargestellten Elemente des Anregungs-Strahlengangs auf die obige Beschreibung verwiesen werden kann.

Das Ausführungsbeispiel des Scanmikroskops 142 in Figur 4 unterscheidet sich von dem Beispiel in Figur 3 hingegen im Detektionsstrahlengang. So ist im Strahlengang des Detektionslichts 164 ein dicroitischer Strahlteiler 170 angeordnet, welcher das Detektionslicht 164 in Detektionslicht in einem ersten Wellenlängenbereich (Bezugsziffer 172) und Detektionslicht in einem zweiten Wellenlängenbereich (Bezugsziffer 174) aufspaltet. Beide Arten von Detektionslicht 172, 174 werden anschließend, analog zum Aufbau in Figur 3, durch Linsensysteme 166 und jeweils eine Blende 168 auf separate Lichtdetektoren 110 abgebildet, beispielsweise wiederum Lichtdetektoren 110 mit Zeilenarrays 112. Auf diese Weise können beispielsweise spektrale Fluoreszenzinformationen aus unterschiedlichen Wellenlängenbereichen gleichzeitig für eine Bildzeile der Probe 158 durch separate Zeilenarrays 112 erfasst und parallel ausgelesen werden. Auf diese Weise lassen sich beispielsweise von biologischen oder medizinischen Proben Aufnahmen mit hohem Kontrast erzielen.

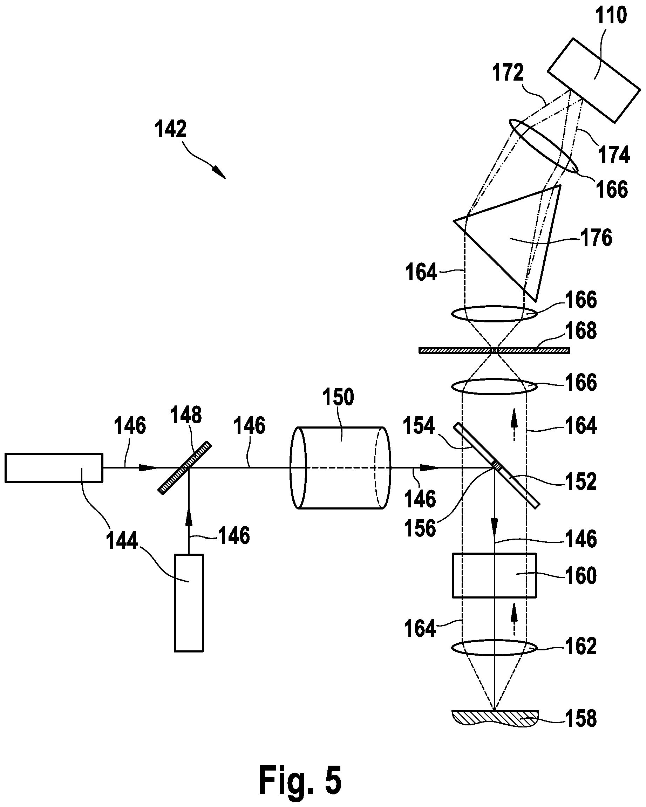

In Figur 5 ist ein drittes Ausführungsbeispiel eines erfindungsgemäßen Scanmikroskops 142 schematisch dargestellt. Wiederum kann für die Beschreibung des Anregungs-Strahlengangs zur Erzeugung der Anregungsstrahlen 146 weitgehend auf die obige Beschreibung verwiesen werden.

Auch im Detektionsstrahlengang entspricht der Aufbau des Ausführungsbeispiels gemäß Figur 5 zunächst dem Ausführungsbeispiel in Figur 3. Das Detektionslicht 164 passiert wiederum die Linsensysteme 166 und die Blende 168, analog zum Ausführungsbeispiel in Figur 3.

Im Unterschied zu Figur 3 ist jedoch anschließend an die Linsensysteme 166 und die Blende 168 ein Prisma 176 vorgesehen, welches eine spektrale Aufspaltung des Detektionslichts 164 vornimmt. Dies ist in Figur 5 lediglich symbolisch durch die Bezugsziffern 172 und 174 dargestellt, wobei jedoch in der Regel ein Prisma 176 eine spektrale Aufspaltung in ein kontinuierliches Spektrum vornimmt, nicht lediglich in zwei Wellenlängenbereiche 172, 174.

Der erfindungsgemäße Lichtdetektor 110 kann in diesem Ausführungsbeispiel auf unterschiedliche Weise genutzt werden. Eine erste Möglichkeit wäre beispielsweise eine Verwendung eines Lichtdetektors 110 mit einem einzelnen Zeilenarray 112, in Verbindung mit einem Punktscan-Mikroskop 142. In diesem Ausführungsbeispiel würde die Probe 158 punktweise von den Anregungsstrahlen 146 abgerastert. Zu jedem Bildpunkt auf der Probe 158 wäre der Detektor 110 dann beispielsweise derart ausgestaltet, dass jede einzelne APD 114 des Zeilenarrays 112 Informationen des einzelnen Bildpunkts der Probe 158 in unterschiedlichen Wellenlängenbereichen aufnimmt. Auf diese Weise kann mit hoher Abtastrate aufgrund des verwendeten APD-Zeilenarrays 112 und der parallelen Auslesung desselben, innerhalb kürzester Zeit ein Bild der Probe 158 aufgenommen werden, bei welchem zu jedem Bildpunkt spektrale Informationen aus einer Vielzahl von Wellenlängenbereichen zur Verfügung stehen.

In einer Abwandlung dieses Gedankens kann der Lichtdetektor 110 auch derart ausgestaltet sein, dass dieser mehrere Zeilenarrays 112 aufweist. In diesem Falle könnte beispielsweise ein Zeilenscan durchgeführt werden, so dass wiederum Bildinformationen einer gesamten Bildzeile der Probe 158 gleichzeitig aufgenommen werden können. Dabei können mehrere parallel angeordnete Zeilenarrays 112 im Detektor 110 vorgesehen sein, wobei jedes Zeilenarray 112 einem anderen Wellenlängenbereich entspricht. Sind beispielsweise 5 oder 10 Zeilenarrays 114 parallel angeordnet, so können beim Zeilenscan Bildinformationen einer gesamten Bildzeile in 5 bzw. 10 Wellenlängenbereichen gleichzeitig aufgenommen werden. Auch diese Ausgestaltung ermöglicht eine äußerst schnelle und komfortable Bildaufnahme, bei welcher der erfindungsgemäße Lichtdetektor 110 mit seiner hohen Auslesegeschwindigkeit und hohen Empfindlichkeit äußerst vorteilhaft eingesetzt werden kann.

### Bezugszeichenliste

- 110: Lichtdetektor
- 112: Zeilenarray
- 114: Avalanche-Halbleiterdetektoren, APDs
- 116: Ansteuerschaltung
- 118: Parallelzähler
- 120: Verbindungsleitungen
- 122: Vorspannung
- 124: Messwiderstand
- 126: Masse
- 127: Vorwiderstand
- 128: Messleitungen
- 129: Transistorschalter
- 130: Photon
- 131: Delay
- 132: Schnittstelle
- 134: erstes Zeilenarray
- 136: zweites Zeilenarray
- 137: Mikrolinsen
- 138: Vorwiderstand
- 140: Knotenpunkte
- 142: Scanmikroskop
- 144: Laser-Lichtquellen
- 146: Anregungsstrahlen
- 148: Strahlteiler
- 150: Strahlformung
- 152: räumlich trennender Strahlteiler
- 154: Bereiche geringer Reflektivität
- 156: Bereiche hoher Reflektivität
- 158: Probe
- 160: Scaneinrichtung
- 162: Objektiv
- 164: Detektionslicht
- 166: Linsensysteme
- 168: Blende
- 170: dichroitischer Strahlteiler
- 172: Detektionslicht erster Wellenlängenbereich
- 174: Detektionslicht zweiter Wellenlängenbereich
- 176: Prisma

## Patentansprüche

1. Zeilenscanmikroskop (142), umfassend
eine Lichtquelle (144) zur Beleuchtung einer Probe (158),
eine Scaneinrichtung (160), die ausgestaltet ist, die Probe (158) mit einem von der Lichtquelle (144) ausgehenden Lichtstrahl (146) zeilenweise abzutasten, und einen Lichtdetektor (110), der derart in dem Zeilenscanmikroskop (142) angeordnet ist, dass er von der Probe (158) emittiertes und/oder transmittiertes und/oder reflektiertes Licht (164) detektiert,
wobei der Lichtdetektor (110) ein Zeilenarray (112) von Avalanche-Halbleiterdetektoren (114) umfasst, das derart ausgestaltet ist, dass es Bildpunkte einer gesamten Bildzeile gleichzeitig aufnehmen kann, wobei der Lichtdetektor (110) eine elektronische Ansteuerschaltung (116) aufweist, die einen Parallelzähler (118) aufweist, wobei der Parallelzähler (118) ausgestaltet ist, um durch die Avalanche-Halbleiterdetektoren (114) detektierte Lichtpulse parallel auszulesen, und wobei der Parallelzähler (118) eingerichtet ist, um während einer vorgegebenen Zählzeit die von den Avalanche-Halbleiterdetektoren (114) detektierten Lichtpulse zu summieren,
**dadurch gekennzeichnet, dass** die Ansteuerschaltung (116) ausgestaltet ist, um die Avalanche-Halbleiterdetektoren (114) in einem Geiger-Modus mit interner Ladungsverstärkung und/oder in einem linearen Modus zu betreiben, wobei der Lichtdetektor (110) mindestens ein erstes Zeilenarray (112) und mindestens ein zweites Zeilenarray (112) umfasst, wobei jeweils mindestens ein erster Avalanche-Halbleiterdetektor (114) des ersten Zeilenarrays (112) und ein zweiter Avalanche-Halbleiterdetektor (114) des zweiten Zeilenarrays (112) einander zugeordnet sind, wobei die Ansteuerschaltung (116) eingerichtet ist, um die Summe der durch den ersten Avalanche-Halbleiterdetektor (114) und durch den zweiten Avalanche-Halbleiterdetektor (114) detektierten Lichtpulse zu erfassen.

2. Zeilenscanmikroskop (142) nach dem vorhergehenden Anspruch, wobei der Parallelzähler (118) mindestens eines der folgenden Elemente umfasst: einen FPGA, einen CPLD.

3. Zeilenscanmikroskop (142) nach einem der beiden vorhergehenden Ansprüche, wobei das Zeilenarray (112) mindestens 256 Avalanche-Halbleiterdetektoren (114) umfasst, vorzugsweise mindestens 512 Avalanche-Halbleiterdetektoren (114), und besonders bevorzugt mindestens 1024 Avalanche-Halbleiterdetektoren (114).

4. Zeilenscanmikroskop (142) nach einem der vorhergehenden Ansprüche, wobei der lineare Füllfaktor des Zeilenarrays (112) mindestens 50 % beträgt, vorzugsweise mindestens 70 % und besonders bevorzugt mindestens 80 %.

5. Zeilenscanmikroskop (142) nach einem der vorhergehenden Ansprüche, wobei das Zeilenarray (112) als ein monolithisches Zeilenarray (112) ausgestaltet ist.

6. Zeilenscanmikroskop (142) nach einem der vorhergehenden Ansprüche, wobei Signale des ersten Avalanche-Halbleiterdetektors (114) und des zweiten Avalanche-Halbleiterdetektors (114) zu einem Summensignal addiert werden und ein gemeinsamer Zähleingang des Parallelzählers (118) mit dem Summensignal beaufschlagt wird.

7. Zeilenscanmikroskop (142) nach einem der vorhergehenden Ansprüche, wobei Signale des ersten Avalanche-Halbleiterdetektors (114) und Signale des zweiten Avalanche-Halbleiterdetektors (114) auf getrennte Zähleingänge des Parallelzählers (118) geschaltet sind, wobei der Parallelzähler (118) eingerichtet ist, um die Signale des ersten Avalanche-Halbleiterdetektors (114) und Signale des zweiten Avalanche-Halbleiterdetektors (114) zu addieren.

8. Zeilenscanmikroskop (142) nach einem der vorhergehenden Ansprüche, wobei der Parallelzähler (118) einen Speicherbereich mit mehreren Speicherzellen umfasst, wobei die Speicherzellen Avalanche-Halbleiterdetektoren (114) zugeordnet sind, wobei die Speicherzellen mit vorgegebenen Werten belegt sind, wobei die Ansteuerschaltung (116) eingerichtet ist, um den Wert einer Speicherzelle kurzfristig zu erhöhen oder zu erniedrigen, wenn der der Speicherzelle zugeordnete Avalanche-Halbleiterdetektor (114) einen Lichtpuls detektiert.

9. Zeilenscanmikroskop (142) nach den beiden vorhergehenden Ansprüchen, wobei die Ansteuerschaltung (116) eingerichtet ist, um in vorgegebenen Zeitabständen die Werte von einander zugeordneten Speicherzellen zu addieren und anschließend die Werte der Speicherzellen wieder auf die vorgegebenen Werte zurückzusetzen.

10. Zeilenscanmikroskop (142) nach einem der vorhergehenden Ansprüche, wobei das Zeilenarray (112) weiterhin eine Vielzahl von Mikrolinsen (137) umfasst, welche eingerichtet sind, um auftreffendes Licht auf jeweils einem oder mehreren Avalanche-Halbleiterdetektoren (114) zu bündeln.

11. Zeilenscanmikroskop (142) nach einem der vorhergehenden Ansprüche, wobei die Ansteuerschaltung (116) weiterhin eine Vorrichtung zur aktiven Löschung der Avalanche-Halbleiterdetektoren (114) aufweist, welche durch ein Signal der Avalanche-Halbleiterdetektoren (114) schaltbar sind, wodurch eine Impedanz eines die Avalanche-Halbleiterdetektoren (114) beinhaltenden RC-Schaltkreises (114, 124, 127) veränderbar ist.

12. Zeilenscanmikroskop (142) nach einem der vorhergehenden Ansprüche, wobei das Zeilenscanmikroskop (142) als Konfokalmikroskop ausgestaltet ist.

13. Zeilenscanmikroskop (142) nach einem der vorhergehenden Ansprüche, weiterhin aufweisend mindestens ein spektrales Trennelement, insbesondere ein Prisma (176) und/oder ein Gitter, wobei das spektrale Trennelement derart eingerichtet ist, dass mindestens zwei unterschiedliche Wellenlängenbereiche (172, 174) eines Bereichs der Probe (158) auf unterschiedliche Avalanche-Halbleiterdetektoren (114) des Lichtdetektors (110) abgebildet werden.

## Claims

1. Line-scanning microscope (142), comprising
a light source (144) for illuminating a sample (158),
a scanning device (160) configured to scan the sample (158) line by line with a light beam (146) coming from the light source (144), and
a light detector (110) arranged in the line-scanning microscope (142) such that it detects light (164) that is emitted by the sample (158) and/or transmitted and/or reflected,
wherein the light detector (110) comprises a line array (112) of avalanche semiconductor detectors (114) that is configured such that it can record image points of an entire image line at the same time, wherein the light detector (110) has an electronic actuation circuit (116) having a parallel counter (118), wherein the parallel counter (118) is configured to read in parallel light pulses detected by the avalanche semiconductor detectors (114), and wherein the parallel counter (118) is set up to add up during a predetermined counting time the light pulses detected by the avalanche semiconductor detectors (114),
**characterized in that** the actuation circuit (116) is configured to operate the avalanche semiconductor detectors (114) in a Geiger mode with internal charge amplification and/or in a linear mode,
wherein the light detector (110) comprises at least one first line array (112) and at least one second line array (112), wherein in each case at least one first avalanche semiconductor detector (114) of the first line array (112) and one second avalanche semiconductor detector (114) of the second line array (112) are assigned to one another, wherein the actuation circuit (116) is configured to capture the sum of the light pulses detected by the first avalanche semiconductor detector (114) and by the second avalanche semiconductor detector (114).

2. Line-scanning microscope (142) according to the preceding claim, wherein the parallel counter (118) comprises at least one of the following elements: an FPGA, a CPLD.

3. Line-scanning microscope (142) according to one of the two preceding claims, wherein the line array (112) comprises at least 256 avalanche semiconductor detectors (114), preferably at least 512 avalanche semiconductor detectors (114), and with particular preference at least 1024 avalanche semiconductor detectors (114).

4. Line-scanning microscope (142) according to one of the preceding claims, wherein the linear fill factor of the line array (112) is at least 50%, preferably at least 70%, and with particular preference at least 80%.

5. Line-scanning microscope (142) according to one of the preceding claims, wherein the line array (112) is embodied as a monolithic line array (112).

6. Line-scanning microscope (142) according to one of the preceding claims, wherein signals of the first avalanche semiconductor detector (114) and of the second avalanche semiconductor detector (114) are added up to give a sum signal, and the sum signal is applied to a common counting input of the parallel counter (118).

7. Line-scanning microscope (142) according to one of the preceding claims, wherein signals of the first avalanche semiconductor detector (114) and signals of the second avalanche semiconductor detector (114) are switched to separate counting inputs of the parallel counter (118), wherein the parallel counter (118) is configured to add up the signals of the first avalanche semiconductor detector (114) and signals of the second avalanche semiconductor detector (114).

8. Line-scanning microscope (142) according to one of the preceding claims, wherein the parallel counter (118) comprises a storage region having a plurality of storage cells, wherein the storage cells are assigned to avalanche semiconductor detectors (114), wherein the storage cells are occupied with predetermined values, wherein the actuation circuit (116) is set up to increase or lower the value of a storage cell in the short term when the avalanche semiconductor detector (114) that is assigned to the storage cell detects a light pulse.

9. Line-scanning microscope (142) according to the two preceding claims, wherein the actuation circuit (116) is set up to add up in predetermined time intervals the values of mutually assigned storage cells and to subsequently reset the values of the storage cells to the predetermined values.

10. Line-scanning microscope (142) according to one of the preceding claims, wherein the line array (112) furthermore comprises a multiplicity of microlenses (137) that are set up to focus incident light onto in each case one or a plurality of avalanche semiconductor detectors (114) .

11. Line-scanning microscope (142) according to one of the preceding claims, wherein the actuation circuit (116) furthermore has an apparatus for the active deletion of the avalanche semiconductor detectors (114) that are switchable by way of a signal of the avalanche semiconductor detectors (114), as a result of which an impedance of an RC circuit (114, 124, 127) including the avalanche semiconductor detectors (114) is able to be changed.

12. Line-scanning microscope (142) according to one of the preceding claims, wherein the line-scanning microscope (142) is embodied in the form of a confocal microscope.

13. Line-scanning microscope (142) according to one of the preceding claims, furthermore having at least one spectral separation element, in particular a prism (176) and/or a grating, wherein the spectral separation element is set up such that at least two different wavelength ranges (172, 174) of a region of the sample (158) are imaged onto different avalanche semiconductor detectors (114) of the light detector (110).

## Revendications

1. Microscope à balayage linéaire (142), comprenant une source lumineuse (144) destinée à éclairer un échantillon (158),
un dispositif de balayage(160) qui est conçu pour explorer ligne par ligne l'échantillon (158) avec un faisceau lumineux (146) sortant de la source lumineuse (144), et
un détecteur de lumière (110) qui est agencé dans le microscope à balayage linéaire (142) de manière à détecter la lumière (164) émise et/ou transmise et/ou réfléchie par l'échantillon (158),
dans lequel le détecteur de lumière (110) comprend un réseau de lignes (112) de détecteurs à semi-conducteurs à avalanche (114) qui est conçu de manière à ce qu'il puisse acquérir simultanément des pixels de la totalité d'une ligne d'image, dans lequel le détecteur de lumière (110) comporte un circuit de commande électronique (116) qui comporte un compteur parallèle (118), dans lequel le compteur parallèle (118) est conçu pour lire en parallèle des impulsions lumineuses détectées par les détecteurs à semi-conducteurs à avalanche (114), et dans lequel le compteur parallèle (118) est conçu pour sommer les impulsions lumineuses détectées par les détecteurs à semi-conducteurs à avalanche (114) pendant un temps de comptage prédéterminé,
**caractérisé en ce que** le circuit de commande (116) est configuré pour faire fonctionner les détecteurs à semi-conducteurs à avalanche (114) dans un mode Geiger avec une amplification de charge interne et/ou dans un mode linéaire,
dans lequel le détecteur de lumière (110) comprend au moins un premier réseau de lignes (112) et au moins un deuxième réseau de lignes (112), dans lequel au moins un premier détecteur à semi-conducteur à avalanche (114) du premier réseau de lignes (112) et un deuxième détecteur à semi-conducteur à avalanche (114) du deuxième réseau de lignes (112) sont respectivement associés l'un à l'autre, dans lequel le circuit de commande (116) est conçu pour détecter la somme des impulsions lumineuses détectées par le premier détecteur à semi-conducteur à avalanche (114) et par le deuxième détecteur à semi-conducteur à avalanche (114).

2. Microscope à balayage linéaire (142) selon la revendication précédente, dans lequel le compteur parallèle (118) comprend au moins l'un des éléments suivants : un PGFA, un CPLD.

3. Microscope à balayage linéaire (142) selon l'une des revendications précédentes, dans lequel le réseau de lignes (112) comprend au moins 256 détecteurs à semi-conducteurs à avalanche (114), de préférence au moins 512 détecteurs à semi-conducteurs à avalanche (114), et de manière particulièrement préférée au moins 1024 détecteurs à semi-conducteurs à avalanche (114).

4. Microscope à balayage linéaire (142) selon l'une des revendications précédentes, dans lequel le facteur de remplissage linéaire du réseau de lignes (112) est d'au moins 50%, de préférence d'au moins 70% et de manière particulièrement préférée d'au moins 80%.

5. Microscope à balayage linéaire (142) selon l'une des revendications précédentes, dans lequel le réseau de lignes (112) est configuré sous la forme d'un réseau de lignes (112) monolithique.

6. Microscope à balayage linéaire (142) selon l'une des revendications précédentes, dans lequel des signaux du premier détecteur à semi-conducteur à avalanche (114) et du deuxième détecteur à semi-conducteur à avalanche (114) sont additionnés afin d'obtenir un signal de somme et le signal de somme est appliqué à une entrée de comptage commune du compteur parallèle (118).

7. Microscope à balayage linéaire (142) selon l'une des revendications précédentes, dans lequel des signaux du premier détecteur à semi-conducteur à avalanche (114) et des signaux du deuxième détecteur à semi-conducteur à avalanche (114) sont commutés sur des entrées de comptage séparées du compteur parallèle (118), dans lequel le compteur parallèle (118) est conçu pour additionner les signaux du premier détecteur à semi-conducteur à avalanche (114) et des signaux du deuxième détecteur à semi-conducteur à avalanche (114).

8. Microscope à balayage linéaire (142) selon l'une des revendications précédentes, dans lequel le compteur parallèle (118) comprend une zone de mémoire comportant plusieurs cellules de mémoire, dans lequel les cellules de mémoire sont associées à des détecteurs à semi-conducteurs à avalanche (114), dans lequel des valeurs prédéterminées sont affectées aux cellules de mémoire, dans lequel le circuit de commande (116) est conçu pour incrémenter ou décrémenter à court terme la valeur d'une cellule de mémoire lorsque le détecteur à semi-conducteur à avalanche (114) associé à la cellule de mémoire détecte une impulsion lumineuse.

9. Microscope à balayage linéaire (142) selon les deux revendications précédentes, dans lequel le circuit de commande (116) est conçu pour additionner les valeurs de cellules de mémoire associées les unes aux autres à des intervalles de temps prédéterminés puis pour réinitialiser les valeurs des cellules de mémoire aux valeurs prédéterminées.

10. Microscope à balayage linéaire (142) selon l'une des revendications précédentes, dans lequel le réseau de lignes (112) comprend en outre une pluralité de microlentilles (137) qui sont conçues pour focaliser la lumière incidente sur un ou plusieurs détecteurs à semi-conducteurs à avalanche (114) respectifs.

11. Microscope à balayage linéaire (142) selon l'une des revendications précédentes, dans lequel le circuit de commande (116) comporte en outre un dispositif destiné à déclencher activement les détecteurs à semi-conducteurs à avalanche (114), qui peuvent être amenés à commuter par un signal des détecteurs à semi-conducteurs à avalanche (114), cela permettant de modifier une impédance d'un circuit RC (114, 124, 127) comportant les détecteurs à semi-conducteurs à avalanche (114).

12. Microscope à balayage linéaire (142) selon l'une des revendications précédentes, dans lequel le microscope à balayage linéaire (142) est configuré sous la forme d'un microscope confocal.

13. Microscope à balayage linéaire (142) selon l'une des revendications précédentes, comportant en outre au moins un élément de séparation spectrale, notamment un prisme (176) et/ou un réseau de diffraction, dans lequel l'élément de séparation spectrale est conçu de manière à former une image d'au moins deux plages de longueurs d'onde différentes (172, 174) d'une région de l'échantillon (158) sur différents détecteurs à semi-conducteurs à avalanche (114) du détecteur de lumière (110) .
